# EUROPEAN PATENT APPLICATION

(11) **EP 4 682 938 A1**
(43) Date of publication of application: **21.01.2026**
(21) Application number: 24770272.3
(22) Date of filing: 05.02.2024
(51) Int. Cl.: H01L 21/302

(54) **SUBSTRATE PROCESSING METHOD, SUBSTRATE PROCESSING DEVICE, AND SOFTWARE**

(30) Priority: 13.03.2023 JP 2023038885
(71) Applicant: Tokyo Electron Limited, Tokyo 107-6325 (JP)
(72) Inventor: ASADA, Yasuo, Yamanashi 4070192 (JP); TODA, Satoshi, Yamanashi 4070192 (JP); KIJIMA, Takahiro, Yamanashi 4070192 (JP); KOBAYASHI, Nozomi, Yamanashi 4070192 (JP); HIRAIDE, Keisuke, Yamanashi 4070192 (JP)
(74) Representative: Diehl & Partner
(86) International application number: PCT/JP2024/003638
(87) International publication number: WO 2024/190152

(57) **Abstract**

An etching method disclosed herein involves performing: a step for supplying, from a gas supply source to a gas supply path, each of a first etching gas and a second etching gas, the second etching gas including at least one selected from the group of an ammonia gas and an amine gas; a storage step for storing the first etching gas and the second etching gas in a reservoir provided in the gas supply path, and increasing an internal pressure of the reservoir; and a gas supply step for opening a valve provided downstream of the reservoir in the gas supply path, supplying the first etching gas and the second etching gas stored in the reservoir to a processing container in which a substrate is accommodated, and etching a first film formed on the substrate.

## Description

### TECHNICAL FIELD

The present disclosure relates to a substrate processing method, a substrate processing device, and software.

### BACKGROUND

There may be a case where, when processing a substrate such as a semiconductor wafer (hereinafter referred to as "wafer"), a gas stored in a tank is released into a processing container to perform the processing. Patent document 1 describes a technique in which etching is performed on a substrate for use in a manufacture of a flat panel display (FPD) by releasing respective gases such as He, HCl, and SF₆ stored in tanks.

### [Prior Art Documents]

### [Patent Documents]

Patent Document 1: Japanese Patent No. 5235293

### SUMMARY

The present disclosure provides a technique that enables high uniformity processing across various regions in a surface of a substrate when etching the substrate using a first etching gas and a second etching gas that includes at least one selected from the group of an ammonia gas and an amine gas.

An etching method of the present disclosure includes: supplying each of a first etching gas and a second etching gas that includes at least one selected from the group of an ammonia gas and an amine gas from a gas supply source to a gas supply path; storing the first etching gas and the second etching gas in a reservoir provided in the gas supply path to increase an internal pressure of the reservoir; and supplying the first etching gas and the second etching gas, stored in the reservoir, to a processing container in which a substrate is accommodated by opening a valve provided downstream of the reservoir in the gas supply path, thus etching a first film formed on the substrate.

According to the present disclosure, it is possible to perform high uniformity processing across various regions in a surface of a substrate when etching the substrate using a first etching gas and a second etching gas that includes at least one selected from the group of an ammonia gas and an amine gas.

### BRIEF DESCRIPTION OF DRAWINGS

FIG. 1 is a vertical front cross-sectional view of an etching apparatus according to one embodiment of the present disclosure.
FIG. 2 is a vertical side cross-sectional view of the etching apparatus.
FIG. 3 is a schematic perspective view illustrating an interior of the etching apparatus.
FIG. 4 is a timing chart of processing performed by the etching apparatus.
FIG. 5 is an operational diagram illustrating an operation of the etching apparatus.
FIG. 6 is an operational diagram illustrating an operation of the etching apparatus.
FIG. 7 is a schematic diagram illustrating a vertical cross-section of a wafer surface to be etched.
FIG. 8 is a schematic diagram illustrating a vertical cross-section of the wafer surface to be etched.
FIG. 9 is a schematic diagram illustrating a vertical cross-section of the wafer surface to be etched.
FIG. 10 is a schematic diagram illustrating a vertical cross-section of the wafer surface to be etched.
FIG. 11 is a schematic diagram illustrating a vertical cross-section of the wafer surface to be etched.
FIG. 12 is a schematic diagram illustrating a vertical cross-section of the wafer surface to be etched.
FIG. 13 is a timing chart of another processing performed by the etching apparatus.
FIG. 14 is an operational diagram illustrating an operation of the etching apparatus.
FIG. 15 is a timing chart of another processing performed by the etching apparatus.
FIG. 16 is a timing chart illustrating processing in an evaluation test.

### DETAILED DESCRIPTION

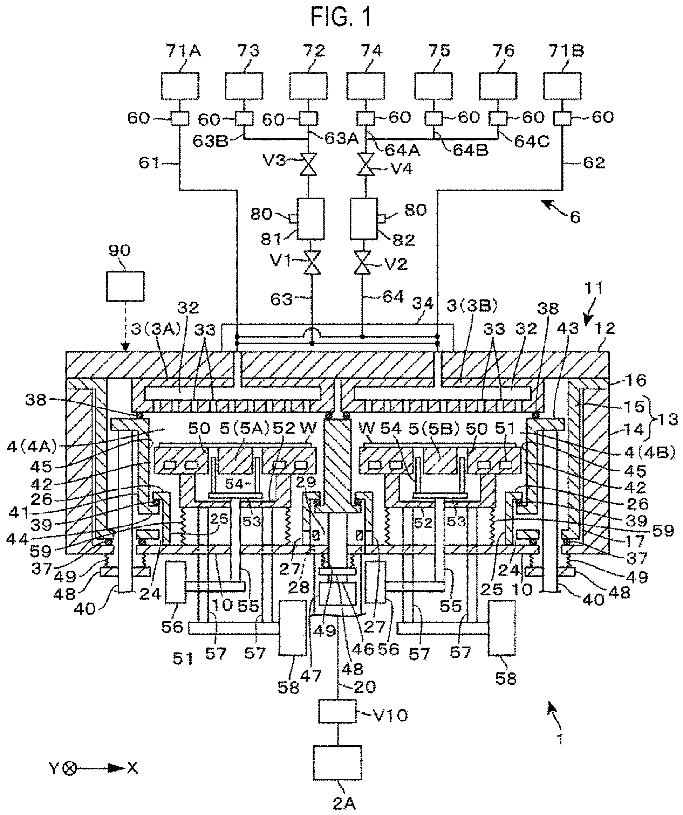

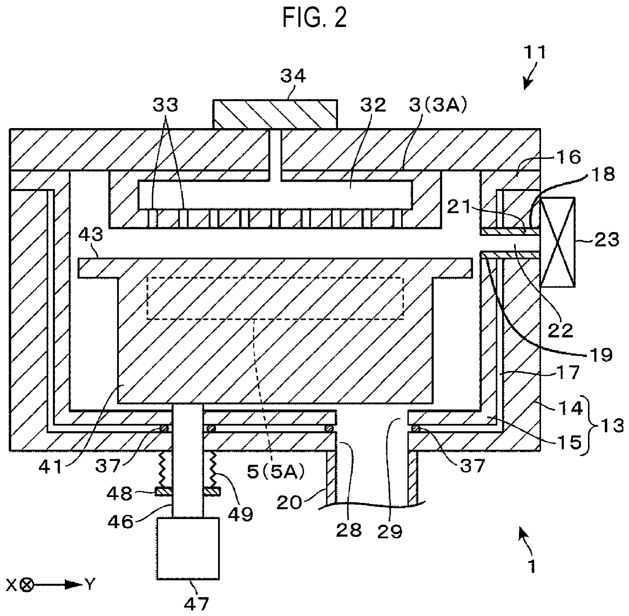

FIGS. 1 and 2 illustrate a vertical front cross-sectional view and a vertical side cross-sectional view, respectively, for an etching apparatus 1, which is one embodiment of an etching apparatus of the present disclosure and performs an etching method according to the present disclosure. An outline of processing performed in the etching apparatus 1 is described first. The etching apparatus 1 performs etching on a surface of a wafer W under a desired pressure in a vacuum atmosphere by using a halogen-containing gas and a basic gas as etching gases. In addition, when performing this etching, no plasma is formed around the wafer W.

A silicon oxide (SiOx) film 101, which is a first film, and a silicon nitride (SiN) 102, which is a second film, are formed on the wafer W transported to the etching apparatus 1, and each of the films is exposed on the surface of the wafer W. Both the SiOx film 101 and the SiN film 102 are etchable by an etching gas. That is, when a halogen-containing gas as a first etching gas and a basic gas as a second etching gas are supplied together, both the SiOx film 101 and the SiN film 102 are etched.

The etching apparatus 1 is configured to selectively etch the SiOx film 101 among the SiOx film 101 and the SiN film 102 and to achieve high uniformity etching in the surface of the wafer W. To describe in detail, the etching apparatus 1 utilizes a difference in incubation time for the etching gases (halogen-containing gas and basic gas) between the SiOx film 101 and the SiN film 102 to perform such selective etching. The incubation time refers to a period from when a gas is adsorbed onto a film on a substrate until a reaction between the gas and the film starts.

A fluorine-containing gas, more specifically, a hydrogen fluoride (HF) gas, is used as the halogen-containing gas, and an ammonia (NH₃) gas or an amine gas is used as the basic gas. More specifically, a trimethylamine (TMA) gas is used as the amine gas. When using these etching gases, the incubation time for the SiOx film 101 is shorter than that for the SiN film 102. In other words, immediately after becoming a state where both the halogen-containing gas and the basic gas are supplied to the wafer W, the SiOx film 101 is etched, while the SiN film 102 is not etched.

The etching apparatus 1 accommodates the wafer W in a processing container 11 in an exhausted state, and stores the etching gases in tanks in a pressurized state. Then, the etching apparatus is configured to release the etching gases from the tanks into the processing container 11. This allows for rapid diffusion of the etching gases into the processing container 11. Then, the supply of etching gases is shut off within a relatively short time after the supply of etching gases starts. The shutoff of the etching gases and exhaust of the processing container 11 causes removal of the etching gases from the processing container 11, thereby preventing etching of the SiN film 102.

The supply and shutoff of the etching gases into the processing container 11 are performed by valves provided downstream of the tanks. By repeatedly opening and closing the valves at a relatively high speed, the SiOx film 101 is selectively etched and an etching amount thereof is controlled as desired. In addition, the etching gases released from the tanks rapidly diffuse into the processing container 11 as described above, which minimizes variations in timings at which the etching gases are adsorbed across various regions in the surface of the wafer W, resulting in high uniformity etching in the surface of the wafer W.

Separate tanks are provided for the halogen-containing gas and the basic gas. That is, the HF gas and the NH₃ gas or TMA gas are stored respectively in separate tanks (tanks 81 and 82). This prevents the halogen-containing gas and the basic gas from reacting with each other while being stored in the tanks. Valves V1 and V2 are provided respectively downstream of the tanks 81 and 82 in accordance with the provision of separate tanks for each gas type.

In this example, opening and closing timings of the valves V1 and V2 are synchronized. That is, a period during which the HF gas is supplied into the processing container 11 coincides with a period during which the NH₃ gas or TMA gas is supplied into the processing container 11. Further, two wafers W are accommodated in the processing container 11 and are placed respectively on stages 5 provided side by side in a left-right direction within the processing container 11. The aforementioned etching is performed simultaneously and equally on the two wafers W. This improves a throughput of the apparatus.

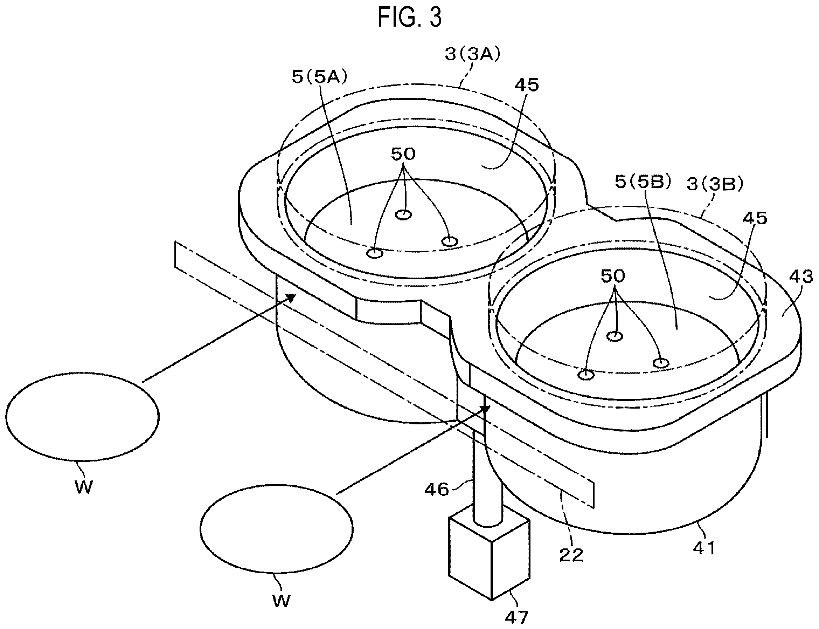

Next, a schematic configuration of the above-described etching apparatus 1 is described with reference also to FIG. 3, which is a perspective view illustrating an interior of the etching apparatus. The aforementioned processing container 11 constituting the etching apparatus 1 is composed of a lid 12 and a container body 13. The container body 13 forms a sidewall and a bottom wall of the processing container 11. The container body 13 includes an outer wall 14 and an inner wall 15, both of which have a recessed shape in a vertical cross-sectional view. The inner wall 15 is positioned inside the outer wall 14, so that the sidewall and bottom wall of the processing container 11 are formed as double walls.

A processing space forming member 41 is surrounded by the inner wall 15. The processing space forming member 41 divides a region enclosed by the container body 13 into a left region and a right region to form two processing spaces 4 where the wafers W are processed respectively. The processing space forming member 41 is vertically movable so as not to interfere with delivery of the wafers W to and from the stages 5. In addition, the two processing spaces 4 may hereinafter be referred to as processing spaces 4A and 4B, for distinction.

Two shower plates 3, spaced apart from each other in the left-right direction, are provided at a lower surface of the lid 12 of the processing container 11. The shower plates 3, together with the processing space forming member 41, form the processing spaces 4A and 4B, and supply gases to the processing spaces 4A and 4B, respectively. Further, the stages 5 on which the wafers W are placed are respectively provided in the processing spaces 4A and 4B. Each stage 5 is vertically movable, so that the wafer W is located at a desired height for processing. Further, the processing spaces 4A and 4B are exhausted through an exhaust port 28, which opens at a bottom center in the left-right direction of the container body 13.

Next, a configuration of each component of the etching apparatus 1 is described in detail. In the following description, the shower plates 3 forming the processing spaces 4A and 4B may be referred to as 3A and 3B, respectively, for distinction. Further, the stages 5 provided in the processing spaces 4A and 4B may be referred to as 5A and 5B, respectively, for distinction. Components used for processing the wafer W in the processing space 4A and components used for processing the wafer W in the processing space 4B that are the same are denoted with the same reference numerals. Further, the left-right and front-rear directions are indicated in the drawings as mutually orthogonal X and Y directions, respectively.

An upper end of the inner wall 15 constituting the container body 13 protrudes outward to form a flange 16, which is supported from below by an upper end of the outer wall 14. In addition, the inner wall 15 is attachable to and detachable from the outer wall 14. A gap 17 is formed between the outer wall 14 and the inner wall 15. As is described later, holes required for the vertical movement of the stages 5 and the processing space forming member 41 within the processing container 11 and exhaust holes are formed in various portions of the inner and outer walls 15 and 14. An O-ring 37, which is a sealing member, is provided along an edge of each hole and is in close contact with both the outer and inner walls 14 and 15. Thereby, the gap 17 does not communicate with these holes and is configured as a sealed space.

An inert gas is supplied to and exhausted from the gap 17 through a gas supply pipe and an exhaust pipe (not illustrated) connected from an outside of the processing container 11, and during the processing of the wafer W, the gap 17 is maintained at a relatively low pressure. This prevents gas leakage from the processing space 4 to the outside of the processing container 11 and provides a heat insulating effect for the processing space 4 against the outside of the processing container 11.

Further, through-holes 18 and 19 are formed respectively at front wall portions of the outer and inner walls 14 and 15 constituting the container body 13. The through-holes 18 and 19 overlap each other in the front-rear direction (Y direction) *(see* FIG. 2). The through-holes 18 and 19 have an elongated slit shape in the left-right direction (X direction), and a tubular member 21, which is elongated in the left-right direction, is in close contact with a peripheral surface forming the through-holes 18 and 19 and extends in the front-rear direction across the through-holes 18 and 19.

A region surrounded by the tubular member 21 is configured as a transport port 22 for the wafer W, and the wafers W pass through left and right regions of the transport port 22 and are delivered to the stages 5A and 5B, respectively. The transport port 22 is opened and closed by a gate valve 23 provided on a front side of the outer wall 14. The wafer W is transported between an interior and exterior of the processing container 11 through the transport port 22 by a transport device (not illustrated).

Further, a peripheral edge of the lid 12 is supported on the flange 16 of the inner wall 15 via a heater (not illustrated) formed along the flange 16. The shower plates 3 (3A and 3B), spaced apart from each other in the left-right direction, are provided on the lower surface of the lid 12. Each shower plate 3 has a circular shape in a plane view, and has a diffusion space 32 for diffusing a gas in a horizontal direction and a gas discharge port 33 connected to the diffusion space 32. Multiple gas discharge ports 33 are formed in a dispersed manner at a lower surface of the shower plate 3 and each open toward an upper surface of the stage 5.

A flow path forming member 34 is provided at an upper side of the lid 12 of the processing container 11. A pipe system 6 to be described later is connected to the flow path forming member 34, and gases supplied from the pipe system 6 are supplied to the diffusion spaces 32 of the shower plates 3A and 3B through a flow path formed in the flow path forming member 34. Lines of the pipe system 6 supplying the aforementioned etching gases are shared by the shower plates 3A and 3B. The flow path in the flow path forming member 34 is configured to distribute the etching gases supplied from these lines to the respective diffusion spaces 32 of the shower plates 3A and 3B.

Two through-holes 24, spaced apart from each other in the left-right direction, are formed at a bottom of the inner wall 15 constituting the container body 13. A bottom portion of the outer wall 14 overlapping each through-hole 24 is configured as a bottom forming portion 10. A lower inner wall 25, which is a vertically standing cylinder, is provided on each bottom forming portion 10. A trunk of the lower inner wall 25 is located within the through-hole 24, and an upper end of the lower inner wall 25 protrudes outward above the through-hole 24 to form a flange 26. Further, an exhaust path 27, which is a through-hole, is formed at a sidewall at a lower end of the lower inner wall 25, thus providing fluid-communication between an interior and an exterior of the lower inner wall 25 through the exhaust path 27.

Further, the exhaust port 28 opens at a bottom of the outer wall 14 at a position between the above-described through-holes 24 in the left-right direction. A through-hole 29 is formed above the exhaust port 28 at the bottom of the inner wall 15, and the exhaust port 28 enables exhaust of a region surrounded by the inner wall 15 through the through-hole 29. One end of an exhaust pipe 20 is connected from below to the bottom of the outer wall 14 so as to open to the exhaust port 28. Then, the other end of the exhaust pipe 20 is connected to an exhauster 2A via a valve V10. The exhauster 2A is composed of, for example, a turbo molecular pump or a dry pump, and an internal pressure of the processing container 11 is adjusted by adjusting an opening degree of the valve V10.

The processing space forming member 41 is described in detail. The processing space forming member 41 is formed to extend in the left-right direction, and has two vertically formed through-holes 42 spaced apart from each other in the left-right direction. Each through-hole 42 serves to form the processing space 4 and has a circular shape in a plane view. An upper rim of the processing space forming member 41 protrudes outward to form an upper flange 43. Further, an O-ring 38 is provided on an upper rim of each through-hole 42 to extend along a periphery of the through-hole 42.

Then, a lower end of each through-hole 42 protrudes inward toward a central axis of the through-hole 42 to form a lower flange 44, and an O-ring 39 is provided on the lower flange 44 along the periphery of the through-hole 42. The lower flange 44 is located below the flange 26 of the lower inner wall 25. In addition, a portion of a peripheral surface forming the through-hole 42 located above the lower flange 44 is referred to as an inner peripheral surface 45.

A central bottom of the processing space forming member 41 in the left-right direction is supported by a pillar 46, and the pillar 46 penetrates a bottom of the processing container 11 and is connected to a lift 47 provided outside the processing container 11. In addition, reference numeral 48 in the drawings denotes a flange provided on the pillar 46 outside the processing container 11. Reference numeral 49 in the drawings denotes a vertically expandable bellows that surrounds the pillar 46 and is connected to both the flange 48 and the bottom of the processing container 11, thereby maintaining airtightness in the processing container 11. In addition, positions of the pillar 46 and the lift 47 are offset rearward relative to a position of the exhaust port 28. The lift 47 vertically moves the processing space forming member 41 between an upper processing position and a lower standby position.

FIGS. 1 and 2 illustrate states where the processing space forming member 41 is at the processing position and the standby position, respectively. At the processing position, the O-ring 38 on the upper flange 43 is in close contact with a peripheral edge of the shower plate 3, and the O-ring 39 on the lower flange 44 is in close contact with the flange 26 of the lower inner wall 25. Therefore, a space surrounded by the shower plate 3, the processing space forming member 41, the lower inner wall 25, and the bottom of the outer wall 14 is formed at the left and right sides in the processing container 11. The stage 5 is provided in this space, and a region above the stage 5 within the space is the processing space 4. Each processing space 4 is exhausted from the exhaust port 28 through the exhaust path 27 of the lower inner wall 25. Further, as illustrated in FIG. 2, at the standby position, an upper end of the processing space forming member 41 is located below the transport port 22, thereby enabling the transport of the wafer W into and out of the processing container 11.

In addition, shafts 40 are provided to extend downward from left and right sides of the upper flange 43 and penetrate the inner and outer walls 15 and 14. The shafts 40 serve to prevent wobbling of the processing space forming member 41 during vertical movement thereof. Each shaft 40 also includes the flange 48, similarly to the pillar 46, and is surrounded by the bellow 49 connected to both the flange 48 and the bottom of the processing container 11, thereby maintaining airtightness in the processing container 11.

In a case where an exhaust path is formed within the processing container 11 as described above, a protective film for corrosion resistance against the etching gases is formed on a portion of the processing container 11 that comes into contact with the etching gases or that is likely to come into contact with the etching gases. Therefore, the protective film is made of a different material from a base material constituting the processing container 11. Specifically, for example, the protective film is formed on a peripheral surface or a bottom surface of the inner wall 15 facing the processing space 4 and on an upper surface of the bottom forming portion 10 of the outer wall 14. The inner wall 15 and the bottom forming portion 10 are attachable to and detachable from other portions constituting the processing container 11, making maintenance of the apparatus easy. The base material of the processing container 11 is, for example, aluminum, and the material of the protective film may be appropriately selected according to a type of etching gas used. If the HF gas, NH₃ gas, and TMA gas are used as in this example, the protective film is made of nickel (Ni), for example.

Next, the stages 5 (5A and 5B) are described. Each stage 5 has a circular shape in a plane view, and has the upper surface facing the lower surface of the shower plate 3 and a side surface facing the inner peripheral surface 45 forming the through-hole 42 of the processing space forming member 41. An upper side of the stage 5 is configured as an electrostatic chuck to attract the wafer W placed on the upper surface of the stage 5. A flow path 51 of a fluid is formed in a lower region of the stage 5. The fluid, which has been adjusted in temperature by a temperature adjuster (not illustrated), is supplied to the flow path 51, thereby adjusting a temperature of the wafer W attracted to the stage 5 to a desired temperature. In addition, the stage 5 is connected to fluid supply and discharge pipes for the flow path 51, but illustration is omitted.

An upper end of an encloser 52, which has a recessed shape in a vertical cross-sectional view, is connected to a lower portion of each stage 5, and a horizontal plate 53 is provided in a sealed space surrounded by the encloser 52 and a lower surface of the stage 5. Three vertically extending pins 54 are provided on the horizontal plate 53 (only two are illustrated in the drawing). The horizontal plate 53 is connected to a pillar 55 that penetrates a bottom of the encloser 52 and the bottom forming portion 10 of the processing container 11, and a lower end of the pillar 55 is connected to a lift 56 provided outside the processing container 11. The pins 54 for supporting the wafer W protrude and retreat relative to the upper surface of the stage 5 by the lift 56, thereby enabling the delivery of the wafer W between the stage 5 and a transport device (not illustrated). In addition, reference numeral 50 in the drawings denotes through-holes formed at the stage 5, through which the pins 54 are inserted.

Further, a pillar 57, which supports the encloser 52 from below, is provided to penetrate the bottom forming portion 10 of the processing container 11, and is connected to a lift 58 provided outside the processing container 11. A vertically expandable bellows 59 surrounds both the pillars 57 and 55, and is surrounded by the lower inner wall 25. The bellows 59 is connected at an upper end thereof to a peripheral edge of the encloser 52 and at a lower end thereof to the bottom of the outer wall 14, thereby maintaining airtightness in the processing container 11, similarly to the bellows 49 described above.

The pillar 57, the lift 58, and the bellows 59 are provided for each stage 5. Therefore, heights of the stages 5A and 5B may be adjusted individually, but in this example, the heights of the stages 5 are aligned, in order to perform the same processing on the wafers W placed on the stages 5A and 5B. In addition, the fact that each stage 5 is vertically movable means that a volume of the processing space 4, which is the region above the stage 5, may be adjusted.

Next, the pipe system 6 is described. The pipe system 6 includes pipes 61, 62, 63 and 64, downstream ends of which are connected to the flow path forming member 34. The pipes 61 and 62 are connected to the shower plates 3A and 3B, respectively. Then, upstream sides of the pipes 61 and 62 are connected to N₂ gas supply sources 71A and 71B via flow rate adjusters 60, respectively. Each of the flow rate adjusters 60 is composed of a valve and a mass flow controller, and performs switching between supply and shutoff of gases to a downstream side of a flow path and adjustment of a gas flow rate. In addition, the flow rate adjusters 60 provided in a pipe other than the pipes 61 and 62 to be described later have the same configuration as the flow rate adjusters 60 provided in the pipes 61 and 62. A nitrogen (N₂) gas supplied from the N₂ gas supply source 71 functions as a carrier gas for the etching gases and also as a purge gas for purging the interior of the processing container 11.

The pipes 63 and 64 are configured as gas flow paths on which reservoirs are installed. A downstream end of the pipe 63 is connected to the shower plates 3A and 3B through the flow path of the flow path forming member 34. Then, the pipe 63 is provided in order toward an upstream side with the valve V1, the tank 81, and a valve V3. Then, the pipe 63 branches off, upstream of the valve V3, into pipes 63A and 63B. The pipe 63A is connected to a HF gas supply source 72 via the flow rate adjuster 60. The pipe 63B is connected to a N₂ gas supply source 73 via the flow rate adjuster 60. A N₂ gas supplied from the N₂ gas supply source 73 is a dilution gas for the HF gas. The valve V3 is opened during a period in which each gas is supplied and stored into the tank 81, which is a first reservoir, and is closed during an opening of the valve V1, which is a first valve, to prevent the gas stored in the tank 81 from backflowing into the pipe 63.

A downstream end of the pipe 64 is connected to the shower plates 3A and 3B through the flow path of the flow path forming member 34. Then, the pipe 64 is provided in order toward an upstream side with the valve V2, the tank 82, and a valve V4. Then, the pipe 64 branches off, upstream of the valve V4, into pipes 64A, 64B and 64C. Each of the pipes 64A to 64C is provided with the flow rate adjuster 60. Then, upstream ends of the pipes 64A, 64B and 64C are respectively connected to a TMA gas supply source 74, an NH₃ gas supply source 75, and a N₂ gas supply source 76. Either an NH₃ gas or a TMA gas is supplied toward the tank 82. A N₂ gas supplied from the N₂ gas supply source 76 is a dilution gas for the NH₃ gas and the TMA gas. The valve V4 is opened during a period in which each gas is supplied and stored into the tank 82, which is a second reservoir, and is closed during an opening of the valve V2, which is a second valve, to prevent the gas stored in the tank 82 from backflowing into the pipe 64.

Each of the tanks 81 and 82 is provided with a pressure sensor 80, which transmits a detection signal regarding an internal pressure of the tanks 81 and 82 to a controller 90 to be described later. The controller 90 may detect the internal pressure of the tanks 81 and 82 based on the detection signal. In addition, the detection signal is transmitted to the controller 90 at intervals shorter than 100 milliseconds, specifically, for example, at 10 millisecond intervals, so that the controller 90 may detect the internal pressure of the tanks 81 and 82 at the same intervals. This pressure detection interval is shorter than a time required for either of the valves V1 and V2 to switch from one of the open state and the closed state to the other. Accordingly, although steps of processing performed on the wafer W are switched by the opening and closing of the valves V1 and V2 as described later, it is possible to detect the pressure of the tanks 81 and 82 in each step and to determine whether there is an abnormality.

As illustrated in FIG. 1, the etching apparatus 1 includes the controller 90, which is a computer, and the controller 90 includes software, a memory, a CPU, an operator, and an alarm output. The operator is a data input device by which a user of the etching apparatus 1 performs various settings, and is configured with, for example, a touch panel. Through the operator, it is possible to perform operation settings when an abnormality occurs in the internal pressure of the tanks 81 and 82 to be described later, and settings related to a processing recipe. Various settings are stored in the memory of the controller 90. The alarm output is configured with, for example, a display or a speaker, and notifies the user of an abnormality or determination result to be described later by displaying a predetermined screen or making a predetermined sound as an alarm.

The software includes instructions (each step) to perform processing of the wafer W to be described later. The software is stored in a recording medium such as a compact disk, a hard disk, a memory card, a magneto-optical disc, or a DVD, and is installed in the controller 90. The controller 90 outputs control signals to each component of the etching apparatus 1 by the software, and controls the operation of each component, thereby executing the processing of the wafer W. Specifically, various operations such as the opening and closing of the valves V1 to V4, adjustment of the opening degree of the valve V10, supply of each gas to a downstream of each pipe by the flow rate adjuster 60, adjustment of the height of the stage 5 by the lift 58, vertical movement of the processing space forming member 41 and the pins 54 by the lifts 47 and 56, and the opening and closing of the transport port 22 by the gate valve 23 are controlled.

The software includes a program for detecting the internal pressure of the tanks 81 and 82 from the above-described detection signal, determining whether the detected pressure falls within a predetermined range, and performing a handling operation when the determination indicates that the detected pressure does not fall within the predetermined range. Examples of the handling operation include stopping processing of the wafer W currently being executed and outputting an alarm, stopping processing of the next wafer W to be transported to the apparatus simultaneously with the output of an alarm (while continuing the processing of the wafer W currently being executed), and only outputting an alarm without stopping the processing of the wafer W. Among these, the operation preset by the user is executed.

Before processing the wafer W, the user selects which processing recipe will be used to process the wafer W. The processing recipe is a combination of parameters related to processing conditions for the wafer W and is stored in the memory of the controller 90. Specific examples of the individual parameters constituting the combination include the internal pressure of the processing container 11, a processing temperature for the wafer W, and parameters related to each gas supplied into the processing container 11. The parameters related to each gas include a timing of gas supply to the downstream by the flow rate adjuster 60, a flow rate at a time of supply, and opening and closing timings of the valves V1 to V4.

The software includes a program that assists in creation of the processing recipe. The program is configured to calculate the respective internal pressures of the tanks 81 and 82 by having the user input parameters before performing the processing of the wafer W, and to determine whether the calculated values are appropriate. Examples of determination of whether the calculated values are appropriate include determining whether the respective internal pressures of the tanks 81 and 82 storing gases fall within an allowable range (i.e., whether they exceed an upper limit threshold or a lower limit threshold) or determining whether an internal pressure difference between the tanks 81 and 82 when both the valves V1 and V2 are opened falls within an allowable range. In addition, the program is configured to output an alarm from the alarm output to notify the user if the determination is that the calculated values do not fall within the allowable ranges.

Further describing the determination of the internal pressure difference between the tanks 81 and 82, in this example, the valves V1 and V2 downstream of the tanks 81 and 82 are opened simultaneously, thereby supplying each gas toward the shower plate 3 as described above. If the internal pressure difference between the tanks 81 and 82 is too large, the gas supplied from one of the tanks 81 and 82 flows toward the other tank through the shower plate 3. That is, gas backflow occurs in the pipe system 6. This may cause unwanted reactions between the gases, potentially preventing proper processing of the wafer W. To prevent such an issue, this program is configured to determine the pressure difference as described above, and output an alarm to prompt the user to reset the parameters if settings are inappropriate. A method of determining the pressure difference is described in detail after describing an operation example of the etching apparatus 1.

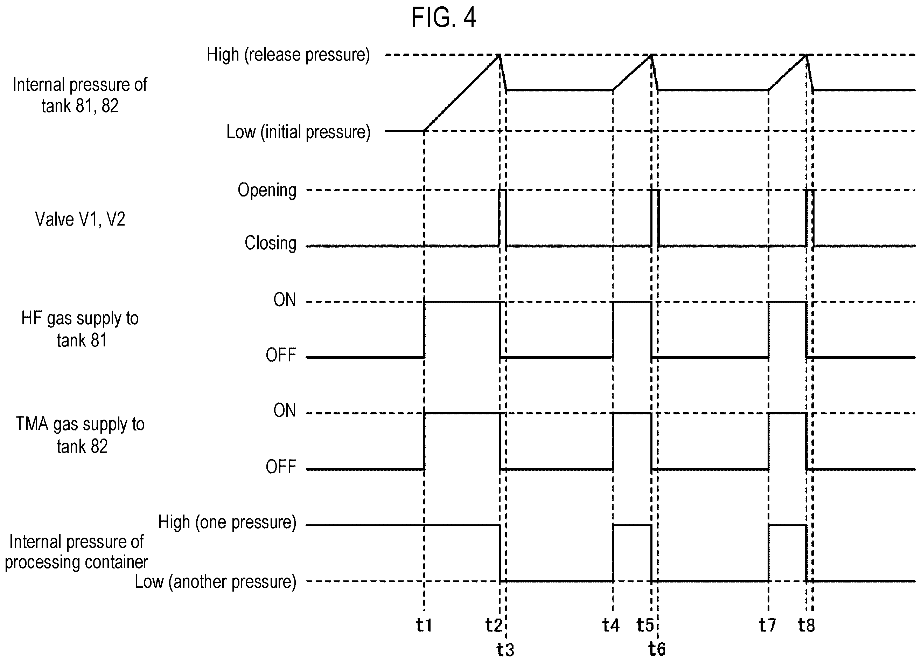

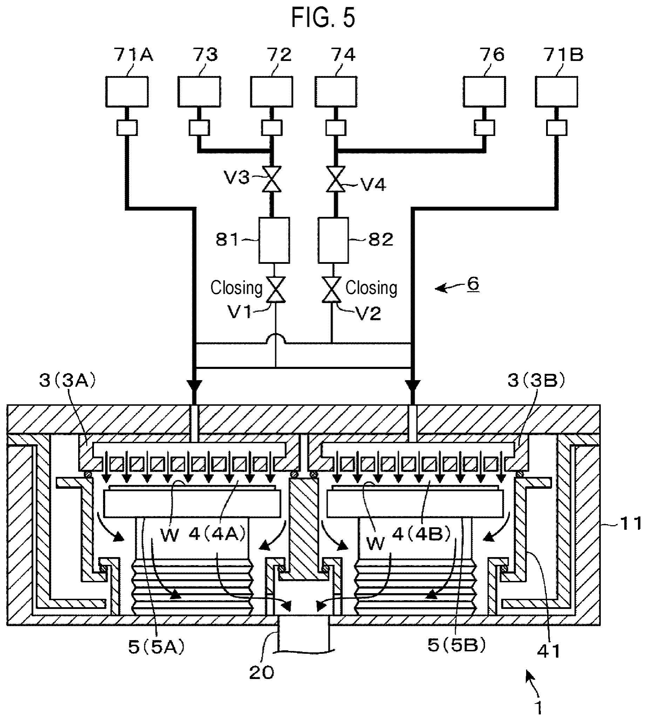

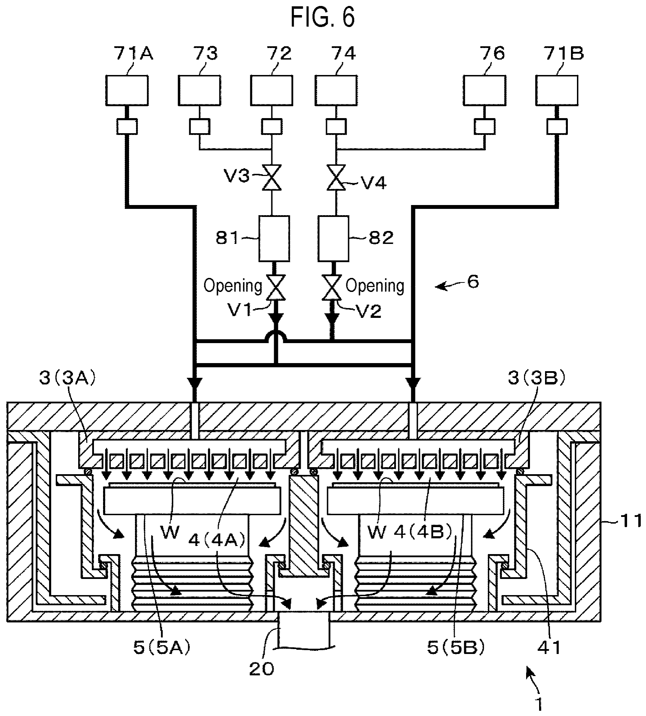

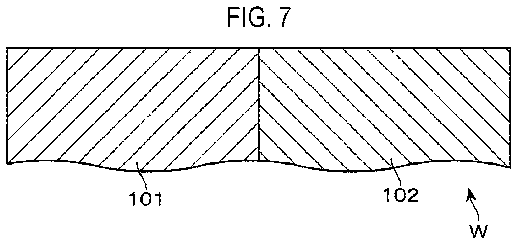

Next, an operation example of the etching apparatus 1 is described with reference to FIG. 4, which is a timing chart, and FIGS. 5 and 6, which illustrate states of a gas supply to the processing container 11 and gas flows within the processing container 11. Further, reference is made as appropriate to FIGS. 7 to 12, which schematically illustrate changes in the surface of the wafer W. In addition, a TMA gas is used in this example, but the same procedure may be used when an NH₃ gas is used instead of the TMA gas.

The timing chart of FIG. 4 illustrates changes in the internal pressure of the tanks 81 and 82, the open/closed states of the valves V1 and V2, a timing of HF gas supply to the tank 81, a timing of TMA gas supply to the tank 82, and changes in the internal pressure of the processing container 11 (i.e., changes in a pressure of the processing space 4). In addition, since the internal pressure of the processing container 11 changes according to the opening degree of the valve V10, this pressure change chart represents changes in the opening degree of the valve V10. In FIGS. 5 and 6, the respective pipes constituting the pipe system 6, through which gases are distributed, are illustrated thicker than other portions. In some of FIGS. 7 to 12, the HF gas and the TMA gas are schematically indicated as 103 and 104, respectively.

First, while the processing space forming member 41 is waiting at the standby position, and the stage 5 is also waiting at a relatively low position so as not to interfere with the transport of the wafer W, two wafers W are transported into the processing container 11 by a transport device. FIG. 7 illustrates the surfaces of the wafers W being transported into the processing container 11. These wafers W are attracted onto the respective stages 5 via the pins 54 and are brought to a desired temperature, for example, within a range from -20 degrees C to 150 degrees C.

After the transport device retreats from the processing container 11, the processing space forming member 31 moves up to the processing position, so that the processing space 4 is formed. The respective stages 5 move up to a predetermined height position and approach the shower plates 3A and 3B, respectively. Then, while the N₂ gas is supplied from the N₂ gas supply sources 71A and 71B to the processing spaces 4A and 4B through the shower plates 3A and 3B, respectively, and the opening degree of the valve V10 is adjusted to a predetermined opening degree (referred to as "first opening degree"), so that the processing spaces 4A and 4B within the processing container 11 reach a single predetermined pressure.

The valves V1 and V2 are closed, and the valves V3 and V4 are opened. Then, the supply of the HF gas and the N₂ gas from the HF gas supply source 72 and the N₂ gas supply source 73 into the tank 81 in an empty state is started, and the supply of the TMA gas and the N₂ gas from the TMA gas supply source 74 and the N₂ gas supply source 76 into the tank 82 in an empty state is started (at time t1 in the chart, *see* FIG. 6). As the respective gases are stored in the tanks 81 and 82, the internal pressure of the tanks 81 and 82 increases from an initial pressure (first pressure) the gas supply is initiated. In a state where the internal pressure of the tanks 81 and 82 reaches a desired second pressure (hereinafter referred to as "release pressure"), the valves V3 and V4 are closed, and the valves V1 and V2 are opened (at time t2). Further, at time t2, the opening degree of the valve V10 is changed to a predetermined second opening degree, which is greater than the first opening degree, and the supply of the HF gas, the TMA gas, and the N₂ gas toward the tanks 81 and 82 is shut off by the flow rate adjuster 60.

As the valves V1 and V2 are opened, the gases stored in the tanks 81 and 82 are released into the processing spaces 4A and 4B and rapidly diffuse throughout the processing space 4 (FIG. 6). Further, as the opening degree of the valve V10 is changed to the second opening degree, an internal pressure of the processing spaces 4A and 4B is lowered to a predetermined pressure (referred to as "another pressure"). This pressure drop further accelerates the diffusion of the respective gases into the processing spaces 4A and 4B. In addition, having the internal pressure of the processing spaces 4A and 4B set at a relatively high pressure (referred to as "one pressure") at the moment the gases are released from the tanks 81 and 82 is to prevent issues caused by an excessively large pressure difference between the tanks 81 and 82 and the processing spaces 4A and 4B. Specifically, this prevents positional shifts of the wafers W due to a pressure of the supplied gas or swirling of particles due to an airflow formed within the processing container 11. In addition, the one pressure and the another pressure in the processing spaces 4A and 4B are, for example, within a range of 0.133 Pa to 666 Pa.

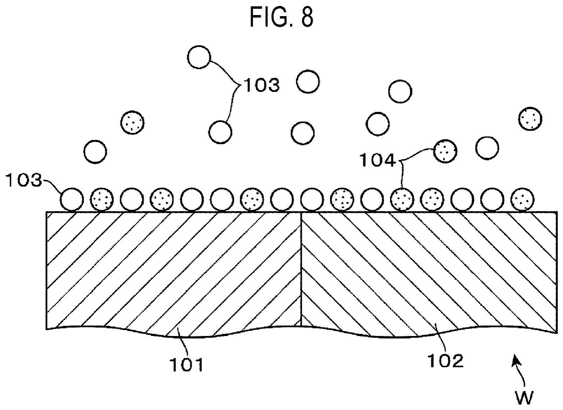

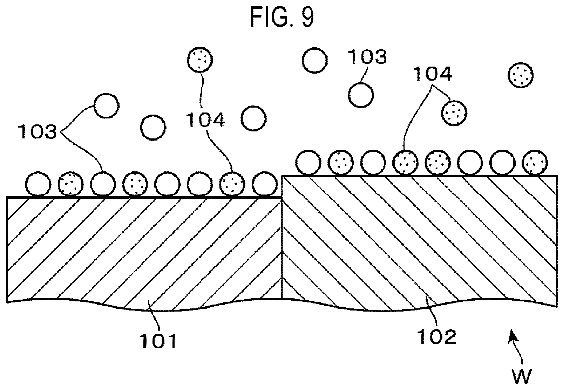

The HF gas 103 and the TMA gas 104, diffused into the processing spaces 4A and 4B, are adsorbed onto the entire surface of the wafer W, i.e., onto the entire surface of each of the SiOx film 101 and the SiN film 102 (FIG. 8). Then, due to the difference in incubation time described above, etching starts only for the SiOx film 101 among the SiOx film 101 and the SiN film 102 (FIG. 9). After that, for example, before an interior of the tanks 81 and 82 returns to the initial pressure, the valves V1 and V2 are closed (at time t3) to shut off the supply of the gases from the tanks 81 and 82 to the processing spaces 4A and 4B. The internal pressure of the tanks 81 and 82 at this time is set to a standby pressure (third pressure). In addition, the valves V1 and V2 are closed promptly in this example, so that (standby pressure - initial pressure) > (release pressure - standby pressure).

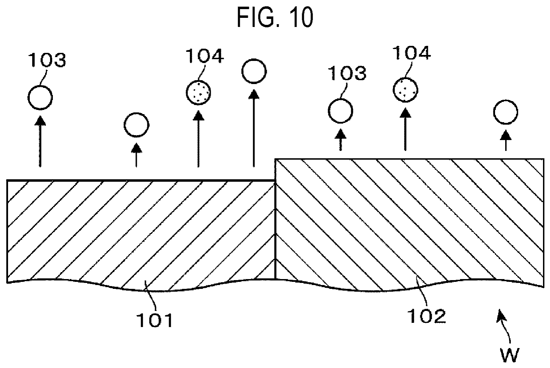

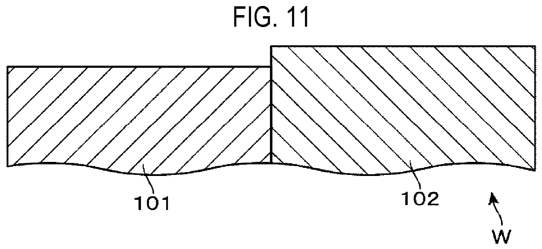

The HF gas 103 and the TMA gas 104 are removed from the processing spaces 4A and 4B by the exhaust of the processing spaces 4A and 4B and the purge action of the N₂ gas supplied from the N₂ gas supply sources 71A and 71B. Since the internal pressure of the processing spaces 4A and 4B is a relatively low pressure (the another pressure), the removal of the HF gas 103 and TMA gas 104 proceeds efficiently, and concentrations of the HF gas 103 and TMA gas 104 in the processing spaces 4A and 4B decrease rapidly. Due to the decreases in the concentrations, the HF gas 103 and TMA gas 104 adsorbed onto the SiOx film 101 and the SiN film 102 desorb from the SiOx film 101 and the SiN film 102 and move to the processing spaces 4A and 4B (FIGS. 10 and 11). Accordingly, the etching of the SiOx film 101 is stopped, and etching on the SiN film 102 is inhibited from starting.

After that, the valves V3 and V4 are opened, and the supply of the HF gas and the N₂ gas to the tank 81 and the supply of the TMA gas and the N₂ gas to the tank 82 by the flow rate adjuster 60. Simultaneously, the opening degree of the valve V10 is returned to the first opening degree (at time t4), and the internal pressure of the processing spaces 4A and 4B increases and returns to the one pressure. Accordingly, at time t4, the same operation as at time t1 is performed, and the processing container 11 returns to the state of FIG. 5.

When the internal pressure of the tanks 81 and 82 increases from the standby pressure to the release pressure, the same operation as at time t2 is performed. That is, the valves V3 and V4 are closed, the valves V1 and V2 are opened, the opening degree of the valve V10 is changed to the second opening degree, and the supply of the HF gas, the TMA gas and the N₂ gas toward the tanks 81 and 82 is shut off by the flow rate adjuster 60 (at time t5). Accordingly, the operation of the apparatus at time t5 is the same as at time t2. By this operation, the gases stored in the tanks 81 and 82 are released into the processing spaces 4A and 4B, while the internal pressure of the processing spaces 4A and 4B is lowered to the another pressure. The processing container 11 once again becomes the state illustrated in FIG. 6, and the selective etching of the SiOx film 101 is resumed.

After that, the valves V1 and V2 are closed in the same manner as at time t3 (at time t6), and the HF gas 103 and the TMA gas 104 are removed from the processing spaces 4A and 4B, so that the etching of the SiOx film 101 is stopped, and the start of the etching of the SiN film 102 is inhibited. Then, the valves V3 and V4 are opened to resume the supply of the HF gas and the N₂ gas to the tank 81 and the supply of TMA gas and the N₂ gas to the tank 82, and the opening degree of the valve V10 is returned to the first opening degree (at time t7). That is, at time t7, the operation of the apparatus is performed in the same manner as at time t4. Then, when the internal pressure of the tanks 81 and 82 increases from the standby pressure to the release pressure, the same operation as at times t2 and t5 is performed (at time t8).

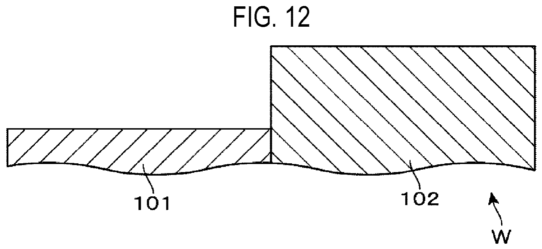

In this way, at times t5 to t8, the series of operations from time t2 to time t5 are performed again. Then, the same operation is repeated after time t8. By performing such a cycle operation, the selective etching of the SiOx film 101 is repeated. When a predetermined number of cycles is completed and an etching amount of the SiOx film 101 becomes a desired amount (FIG. 12), each wafer W is unloaded from the processing container 11 in the reverse procedure to that used during loading into the processing container 11.

As described above, first, a step of storing gases in the tanks 81 and 82 (referred to as "initial storage step") is performed. Thereafter, a cycle including a gas release step of releasing the gases from the tanks 81 and 82 into the processing space 4, an exhaust step of stopping the release of the gases from the tanks 81 and 82 and exhausting the respective gases from the processing space 4, and a re-storage step of supplying a released amount of the gases to the tanks 81 and 82 is repeated, thereby processing the wafer W. The exhaust step and the re-storage step are performed in parallel.

In addition, a period during which the gas release step is performed corresponds to a period during which the valves V1 and V2 are opened, i.e., between times t2 and t3 and between times t5 and t6. The period during which the gas release step is performed once is relatively short, for example, less than 1 second. Therefore, in the above processing example, not all of the gases in the tanks 81 and 82 are released into the processing space 4 when the valves V1 and V2 are opened, and a portion of the gases remains. Accordingly, the initial storage step (from time t1 to time t2) of storing the gases into the empty tanks 81 and 82 is longer than the re-storage step (from time t4 to time t5 and from time t7 to time t8).

As described above, in the etching apparatus 1, a relatively large amount of the HF gas and the TMA gas, which have been pressurized by being stored in the tanks 81 and 82, is released into the processing space 4 when the valves V1 and V2 are opened. Therefore, the HF gas and the TMA gas are widely spread throughout the processing space 4 within a short time, and are adsorbed simultaneously or substantially simultaneously onto the SiOx film 101 across various regions in the surface of the wafer W, thereby starting etching. Therefore, etching uniformity of the SiOx film 101 in the surface of the wafer W may be increased. Further, after the opening of the valves V1 and V2, the valves V1 and V2 are quickly closed. Specifically, by closing the valves V1 and V2 before the interior of the tanks 81 and 82 returns to the initial pressure, the etching of the SiN film 102 may be prevented, and the selective etching of the SiOx film 101 may be performed.

In addition, although the cycle after the initial storage step (from time t1 to time t2) is repeated three or more times in the above description, the number of repetitions is arbitrary. Further, in a case where the required etching amount is small, the cycle may be performed only once without repetition.

Further, in the above processing, the opening degree of the valve V10 is changed simultaneously with the opening of the valves V1 and V2 to lower the internal pressure of the processing space 4, but the timing of changing the opening degree of the valve V10 may be within a predetermined short time before or after the opening timing of the valves V1 and V2. Changing the opening degree of the valve V10 at timings offset from every opening timing of the valves V1 and V2 by a predetermined time is considered to fall within the scope of lowering the internal pressure of the processing container in accordance with the valve opening timing, just as changing the opening degree of the valve V10 simultaneously with the opening timing.

During the execution of the initial storage step and the subsequent cycle, detection signals are continuously transmitted at a predetermined interval from the respective pressure sensors 80 of the tanks 81 and 82 to the controller 90 to monitor the internal pressure of the tanks 81 and 82. A transmission interval of the detection signal is shorter than the period during which the valves V1 and V2 are opened and the gas release step is performed (i.e., between times t2 and t3 and between times t5 and t6). Accordingly, the pressure is detected during each of the gas release step in which the valves V1 and V2 are open and other steps in which the valves V1 and V2 are closed. That is, pressure detection is performed for each period during which the valves V1 and V2 are open and for each period during which the valves V1 and V2 are closed. Then, whether there is an abnormality is monitored based on the pressure. This enables a rapid detection of an abnormality in the operation of the apparatus, thereby preventing a reduction in a yield of semiconductor products manufactured from the wafer W.

Supplemental description is provided below regarding the determination of the internal pressure difference between the tanks 81 and 82 to assist the user in creating a processing recipe. To determine the pressure difference, the internal pressure of each of the tanks 81 and 82 when the downstream valve V1 or V2 is opened is calculated. The following description pertains to the tank 81. As a premise, since a volume of the tank 81 (in cc) is constant, the internal pressure of the tank 81 changes according to a gas supply amount (in cc) to the tank 81 and a gas discharge amount (in cc) from the tank 81. The gas discharge amount is affected by the internal pressure of the tank 81, but it may be considered to change only in response to the internal pressure of the tank 81 if the valve V1 is opened only for a very short duration. Further, in a normal operation state (i.e., the state after time t2 in the above-described chart where the valves V1 and V2 are repeatedly opened and closed), the internal pressure of the tank 81 at each opening timing of the valve V1 is the same, and the gas supply amount equals to the gas discharge amount. In addition, the gas supply amount equals to a flow rate of the gas supplied to the tank 81 × time, and the gas flow rate is a sum of flow rates of the HF gas and the N₂ gas supplied to the tank 81.

Under the above premise, the user sets, as parameters, the period from time t1 to time 2 in FIG. 4 (i.e., a period from when the gas is charged into the empty tank 81 until the valve V1 is opened), and the respective flow rates of the HF gas and the N₂ gas supplied to the tank 81 from the flow rate adjuster 60, which is provided upstream of the tank 81. The period from time t1 to time 2 × the sum of the HF gas flow rate and the N₂ gas flow rate is the gas supply amount to the tank 81. The gas supply amount is set to a value that does not exceed the volume of the tank 81. Then, the internal pressure of the tank 81 at time t2 when the valve V1 is opened is automatically calculated based on the gas supply amount, the volume of the tank 81, and a predetermined calculation formula.

In addition, the gas discharge amount by the opening of the valve V1 is determined by the internal pressure of the tank 81 as described above, and the gas discharge amount is calculated using a predetermined calculation formula based on the calculated internal pressure of the tank 81 at the time when the valve V1 is opened. As described above, the gas discharge amount equals to a gas supply amount needed to compensate for a pressure drop. Then, since (the HF gas flow rate + the N₂ gas flow rate) is already set, a period required to recharge the gas into the tank 81 (i.e., the period from time t4 to time t5 or from time t7 to time t8 in the chart of FIG. 4) may also be automatically calculated from the gas flow rate and the gas supply amount and made known to the user.

As described above, the internal pressure of the tank 81 when the valve V1 is opened may be calculated based on the user settings. Similarly, the internal pressure of the tank 82 when the valve V2 is opened may be calculated by setting a flow rate of each gas supplied to the tank 82 and the period from time t1 to time 2. In addition, the flow rate and the supply period of each gas to the tank 81, set by the user, correspond to first parameters, while the flow rate and the supply period of each gas to the tank 82 correspond to second parameters. The calculated internal pressures (virtual pressures) of the tanks 81 and 82 are used to calculate the internal pressure difference (virtual pressure difference) between the tanks 81 and 82 at the same timing, thus determining whether the calculated pressure difference falls within an allowable range (i.e., detecting whether there is an abnormality).

Although it is assumed that a pressure change in the tank 81 is constant and the gas discharge amount changes only based on the internal pressure of the tank 81 since valve V1 is opened for an extremely short period, in reality, the pressure change in the tank 81 and the gas discharge amount change based on both the internal pressure of the tank 81 and the opening period of the valve V1. Although the internal pressure of the tank 81 at time t2 when the valve V1 is opened is automatically calculated as described above, a predetermined calculation formula may also be prepared to calculate a pressure after completion of the opening of the valve V1 based on the opening period of the valve V1 and the internal pressure of the tank 81 when the valve V1 is opened. Then, a period required for performing gas recharge into the tank 81 after completion of the opening of the valve V1 as described above may also be calculated based on the pressure after completion of the opening of the valve V1 calculated by the calculation formula. In addition, when the gas is supplied to the tank 81 even during the opening of the valve V1, an amount of pressure drop in the tank 81 due to the opening of the valve V1 is reduced by an amount of the gas supplied, which affects both the gas discharge amount from the tank 81 and the pressure change in the tank 81. Therefore, the above calculation formula is set to calculate the pressure after completion of the opening of the valve V1 also based on a supply period and a supply flow rate of the gas during the opening of the valve V1. The opening period of the valve V1 and the supply period and supply flow rate of the gas into the tank 81 during the opening of the valve V1 are all set by the user.

In addition, in the calculation of the internal pressure of the tank 81, a pressure increase in the tank 81 equals to the flow rate of each gas to the tank 81 × the gas supply period × a predetermined coefficient. Further, it is assumed that a pressure drop in the tank 81 occurs in proportion to the opening period of the valve V1, and for example, the pressure drop in the tank 81 equals to the opening period of the valve V1 × a predetermined coefficient. Accordingly, the user sets the period between times t1 and t2 in FIG. 4 and the flow rates of the HF gas and the N₂ gas supplied to the tank 81. Further, the user sets the opening period of the valve V1 between times t5 and t6 during the execution of the cycle, the period between times t4 and t5 corresponding to the gas recharge step during the execution of the cycle, and the flow rates of the HF gas and the N₂ gas supplied to the tank 81. Based on these settings, the internal pressure of the tank 81 at times t2 and t5 when the valve V1 is opened may be calculated. The same parameters are also set for the tank 82, so that the pressure at times t2 and t5 when the valve V2 is opened is calculated. Then, the internal pressure difference between the tanks 81 and 82 at each of times t2 and t5 may be calculated to determine whether it falls within an allowable range. In addition, although it has been described that the individual internal pressures of the tanks 81 and 82 are monitored during the processing of the wafer W, it is also possible to calculate the internal pressure difference between the tanks 81 and 82 and to determine whether there is an abnormality based on the internal pressure difference, similarly to during the creation of the processing recipe.

Incidentally, in a case where the HF and TMA gases, which react on the wafer W through interaction thereof, are used, it is sufficient to provide a state where both gases are supplied to the wafer W. That is, it is sufficient that while one of the gases is adsorbed on the wafer W (i.e., before desorption from the wafer W is completed), the other gas is supplied to the wafer W. Therefore, it is not necessary to supply both gases to the wafer W simultaneously, but the gases may be alternately supplied to the wafer W. In other words, although the processing illustrated in FIG. 4 aligns the opening periods of the valves V1 and V2, it is permissible for the opening periods of the valves V1 and V2 to be offset from each other.

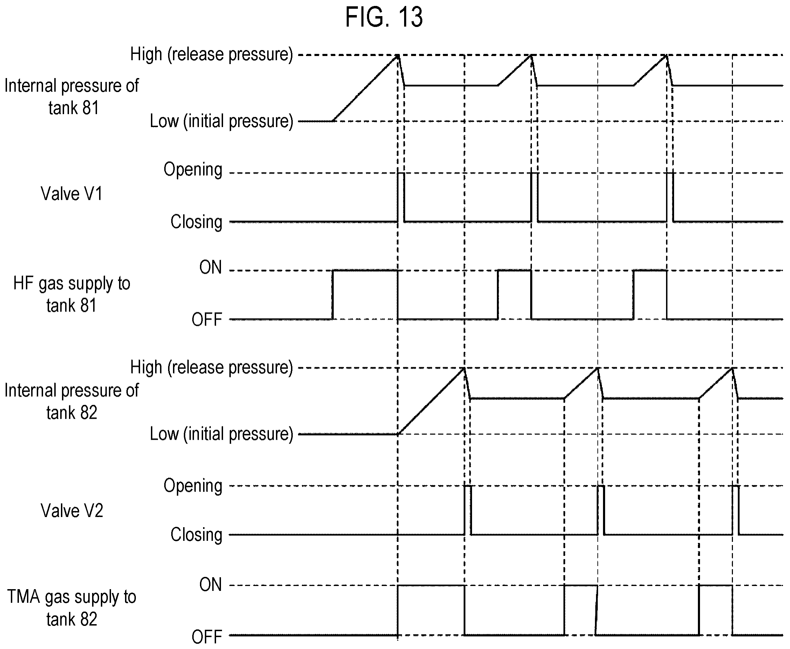

A timing chart illustrated in FIG. 13 illustrates a processing example in which the opening periods of the valves V1 and V2 are offset, and compared with the processing illustrated in the timing chart of FIG. 4, timings of opening the valve V2 and supplying the TMA gas into the tank 82 is delayed. Specifically, the processing, including the release of the HF gas into the processing space 4 by the opening of the valve V1, the closing of the valve V1, the release of the TMA gas into the processing space 4 by the opening of the valve V2, and the closing of the valve V2, is repeated in sequence. The purge and exhaust of the processing space 4 are performed during a time interval between the closing of one of the valves V1 and V2 and the opening of the other. However, one etching gas will desorb from the SiOx film 101 between the supply of the one etching gas to the wafer W and the supply of the other etching gas. Therefore, from the viewpoint of increasing etching performance for the SiOx film 101 and increasing a throughput of the apparatus, it is desirable to align the opening periods of the valves V1 and V2, as in the processing described in FIG. 4.

In addition, the opening timings of the valves V1 and V2 may be offset, and still overlap in the opening periods thereof. Accordingly, for example, the valve V2 may be opened with a slight delay after the valve V1 is opened, such that both the valves V1 and V2 are open to supply the respective gases from the tanks 81 and 82 to the processing space 4. However, to prevent gas backflow from one tank to the other tank through the shower plate 3, it is desirable that the valves V1 and V2 are opened simultaneously.

In order to quickly diffuse the gases supplied from the tanks 81 and 82 into the processing space 4, it is desirable that the volume of the processing space 4 be as small as possible. Accordingly, as illustrated in FIGS. 5 and 6, it is desirable to position the stage 5 close to the shower plate 3 forming a ceiling of the processing container 11. However, it is conceivable that positioning the stage 5 too close to the shower plate 3 is undesirable depending on the processing recipe. For example, in a case where the processing recipe is set such that the internal pressure of the tanks 81 and 82 when the valves V1 and V2 are opened is relatively high, it is conceivable that a gas discharge pressure from the shower plate 3 becomes excessive, potentially causing a damage to a surface region of the wafer W directly below the gas discharge port 33 of the shower plate 3.

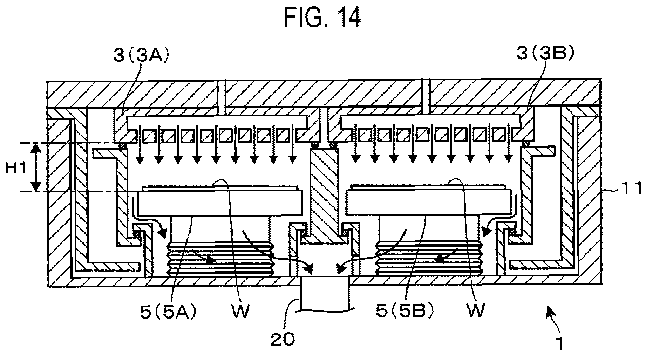

Accordingly, although the stages 5 may be positioned at a uniform height during the processing of the wafer W, it is desirable to position the stages 5 at a height according to the processing condition of the wafer W. FIG. 14, similar to FIG. 5, is a vertical cross-sectional view illustrating the etching apparatus 1 during the processing of the wafer W, in which the height position of the stage 5 is lower than in the example of FIG. 5. When the internal pressure of the tanks 81 and 82 when the valves V1 and V2 are opened is relatively low, the processing may be performed with the stage 5 positioned as in FIG. 5. When the pressure is relatively low, the processing may be performed with the stage 5 positioned as in FIG. 14. When changing the height of the stage 5 in this way, it is desirable that a distance H1 (*see* FIG. 14) between the upper surface of the stage 5 and the shower plate 3 be changeable within a range of, for example, 10 mm to 100 mm. In addition, when the user of the apparatus sets multiple processing recipes, the height of the stage 5 is set in association with each processing recipe, and the association is stored in the memory of the controller 90. When the user selects a processing recipe to be used from among the multiple processing recipes, the stage 5 may be positioned at a height corresponding to the selected processing recipe (i.e., the selected processing condition) based on data in the memory, and the wafer W may be processed accordingly.

In the etching apparatus 1, the SiOx film is etched using the HF gas as the halogen-containing gas and the NH₃ gas or the TMA gas as the basic gas, but the etching is not limited thereto. For example, an etching target film may be a Si film containing oxygen other than the SiOx film, or a SiOCN film. Further, it may also be a silicon oxide film using a tetraethyl ortho silicate gas as a raw material. In addition to the HF gas, various gases such as HCl, HBr, HI, and SF₆ gases may be used as the halogen-containing gas.

Further, an amine other than the TMA gas may be used in the etching of the Si film containing oxygen. Specifically, gases of various amine compounds such as dimethylamine, dimethylethylamine, diethylamine, triethylamine, monotertiarybutylamine, pyrrolidine, and pyridine may be used. Further, other specific examples of amine compounds may include those in which some or all of C-H bonds of the compounds above are replaced with C-F bonds (such as 1,1,1-trifluorodimethylamine).

Further, when performing etching in the etching apparatus 1, it is particularly effective when films having different incubation times, such as the SiOx film 101 and the SiN film 102, are all exposed on the wafer W so that the film with a shorter incubation time is selectively etched, but the etching target film may not be limited thereto. For example, the etching apparatus 1 may be used even when only a single film is exposed on the surface of the wafer W and the film is etched as the etching target film.

In addition, the etching target film is not limited to the Si film containing oxygen as described above, but may be other Si-containing films. Specifically, it may be a silicon-containing film such as a Si film or a SiGe film. To etch these Si and SiGe films, gases such as F₂ gas, IF₇ gas, IF₅ gas, ClF₃ gas, and SF₆ gas may be used as the halogen-containing gas, and an NH₃ gas may be used as the basic gas. In addition, when a compound constituting a film or gas is described herein as "containing" a certain substance, it means that the substance is a main component constituting the compound, not merely present as an impurity.

For example, when etching a Si film using a F₂ gas and an NH₃ gas, AFS ((NH₄)SiF₆), which is a modified substance from the Si film, may remain depending on the processing temperature of the wafer W during gas supply, and the AFS is removed later by heating the wafer W. The etching herein includes not only removal of a film by gases, but also modification of the film. In other words, the processing of modifying the Si film into the AFS as described above is also included in the etching.

Although it has been described that either the NH₃ gas or the amine gas is selected and used, both of the gases may also be used. Accordingly, a mixed gas composed of the NH₃ gas and the amine gas may be supplied to the wafer W. Further, in supplying the mixed gas to the wafer W in this way, both the NH₃ gas and the amine gas may be stored in the tank 82, or the NH₃ gas and the amine gas may be stored separately in individual tanks and then be mixed when supplied into the processing container 11. Accordingly, the number of lines (supply lines) in which tanks are provided is not necessarily limited to two. In addition, the halogen-containing gas and the basic gas may be stored in the same common tank. However, it is desirable to store the halogen-containing gas and the basic gas in separate tanks as described above due to the risk of the reaction between the halogen-containing gas and the basic gas while stored together in the tank.

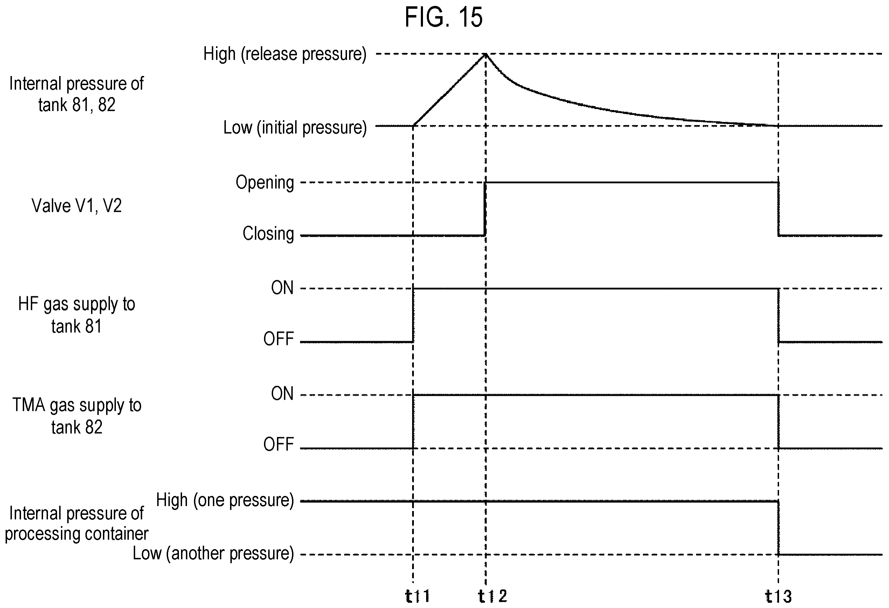

Further, in using the tanks 81 and 82 to process the wafer W, each processing described in the timing charts of FIGS. 4 and 13 involves immediately closing the valves V1 and V2 after the release of gases, but the processing is not limited thereto. As an example of the processing, processing illustrated in a timing chart of FIG. 15 (referred to as "continuous supply processing" for the convenience of description) is described, focusing on differences from the processing described in FIG. 4 (sometimes referred to as "pulse supply processing"). At time t11 in FIG. 15, the supply of the HF gas and the supply of the TMA gas to the tanks 81 and 82 are started, respectively. Accordingly, the operation at time t11 is the same as the operation at time t1 in the pulse supply processing. After that, at time t12, the valves V1 and V2 are opened to supply the gases from the tanks 81 and 82 to the processing spaces 3A and 3B. The operation at time t12 differs from the operation at time t2 in the pulse supply processing in that the valves V3 and V4 are not closed, and the supply of the HF gas and the N₂ gas to the tank 81 from the HF gas supply source 72 and the N₂ gas supply source 73 and the supply of the TMA gas and the N₂ gas to the tank 82 from the TMA gas supply source 74 and the N₂ gas supply source 76 are continuously performed.

The internal pressure of the tanks 81 and 82 drops rapidly due to the release of the pressurized gas inside, and is then gradually lowered to return to the initial pressure. At that point, the valves V1 to V4 are closed, the flow rate adjuster 60 shuts off the supply of the gases from the respective gas supply sources to the tanks 81 and 82, and the opening degree of the valve V10 is changed from the first opening degree to the second opening (at time t13). Then, the internal pressure of the processing space 4 is lowered from a pressure of a position to another pressure, and exhaust of the gases from the processing space 4 proceeds.

By repeating the above series of operations as a cycle operation, a desired amount of the SiOx film 101 is etched. Even in this type of processing, the HF gas and the TMA gas may be rapidly diffused over the entire surface of the wafer W, enabling high uniformity etching of the SiOx film 101 across all regions in the surface of the wafer W. However, since the SiN film 102 is exposed to the HF gas and the TMA gas for a relatively long time, the pulse supply processing as described in FIG. 4 is effective in order to increase etching selectivity of the SiOx film 101.

The embodiments disclosed herein should be considered as illustrative and not restrictive in all respects. The above embodiments may be omitted, replaced, modified and combined in various ways without departing from the scope of the appended claims.

### [Evaluation Test]

Hereinafter, evaluation tests performed in relation to this technique are described. In these evaluation tests, processing was performed on a patterned substrate by using the etching apparatus 1, and states of patterns before and after etching was observed. Then, the etching amounts of the SiOx film 101 and the SiN film 102, which were exposed on the surface of the wafer W and formed the patterns, were measured before and after the etching, and a selectivity ratio (i.e., SiOx film 101 etching amount / SiN film 102 etching amount) was calculated. In Evaluation tests 1-1 to 1-3, the etching was performed in mutually different modes.

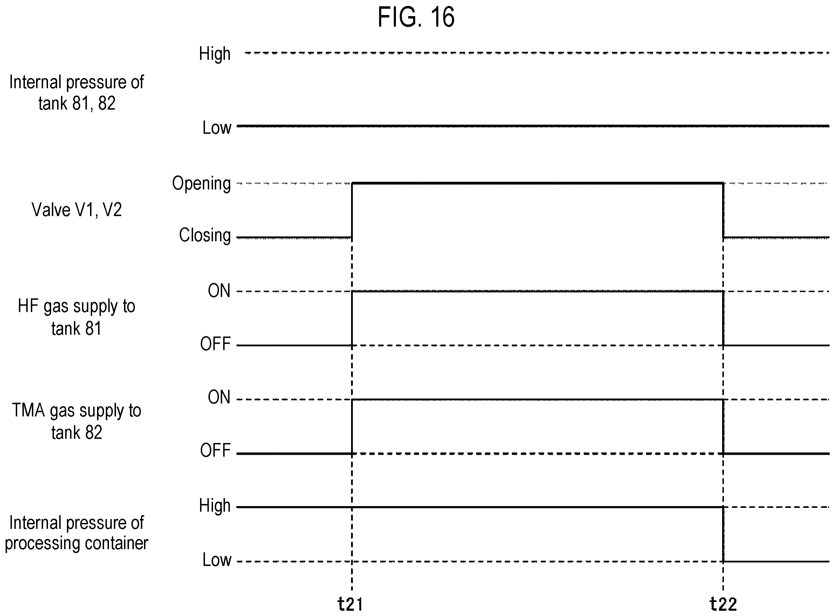

In Evaluation test 1-1, the processing was performed by operating each component of the apparatus as illustrated in a timing chart of FIG. 16. Differences between processing illustrated in FIG. 16 (referred to as "non-pressurized processing") and the pulse supply processing of FIG. 4 are described below. At time t21, each gas was supplied to the tanks 81 and 82 from the flow rate adjuster 60, while the valves V1 and V2, which had been closed, were opened. Then, at time t22, the valves V1 and V2 were closed, and the valve V10, which had been at the first opening degree, was changed to the second opening degree to lower the internal pressure of the processing container 11. When this series of processing is regarded as one cycle, etching was performed on the wafer W by repeating this cycle 5 times. In this way, in Evaluation test 1-1, the tanks 81 and 82 were provided, but the respective gases were supplied to the processing space 4 such that the tanks 81 and 82 do not cause gas storage or pressurization. In Evaluation test 1-2, the continuous supply processing described in FIG. 15 was performed. The number of repetitions of the cycle was five. In Evaluation test 1-3, the pulse supply processing illustrated in FIG. 4 was performed. The cycle after the initial storage step was performed 25 times.

For the selectivity ratio, it was 1.2 in Evaluation Test 1-1, was 3.1 in Evaluation Test 1-2, and was 52.3 in Evaluation Test 1-3. Accordingly, Evaluation Test 1-3 yielded the most desirable results, followed by Evaluation Test 1-2. These test results confirmed effectiveness of supplying the HF gas and the TMA gas into the processing container 11 after storing them in the tanks 81 and 82, respectively. Further, it was found that for the valves V1 and V2, it is effective to close them before the gases are completely released from the tanks 81 and 82 and the internal pressure of the tanks 81 and 82 returns to the initial pressure.

### EXPLANATION OF REFERENCE NUMERALS

W: wafer, 11: processing container, 63, 64: pipe, 72, 74: gas supply source, 81, 82: tank

## Claims

1. An etching method comprising:
supplying each of a first etching gas and a second etching gas that includes at least one selected from the group of an ammonia gas and an amine gas from a gas supply source to a gas supply path;
storing the first etching gas and the second etching gas in a reservoir provided in the gas supply path to increase an internal pressure of the reservoir; and
supplying the first etching gas and the second etching gas, stored in the reservoir, to a processing container in which a substrate is accommodated by opening a valve provided downstream of the reservoir in the gas supply path, thus etching a first film formed on the substrate.

2. The etching method of Claim 1, wherein the first etching gas is a halogen-containing gas, and
wherein the first film is a silicon-containing film.

3. The etching method of Claim 2, comprising:
repeatedly opening and closing the valve to repeatedly perform the supplying the first etching gas and the second etching gas to the processing container, in order to repeatedly etch the first film.

4. The etching method of Claim 3, wherein the storing includes:
initial storing where the internal pressure of the reservoir is increased from a first pressure to a second pressure that is higher than the first pressure; and
restoring the internal pressure of the reservoir, decreased to a third pressure that is lower than the second pressure but higher than the first pressure due to the performing of the supplying the first etching gas and the second etching gas to the processing container, to the second pressure, and
wherein a cycle including the supplying the first etching gas and the second etching gas to the processing container and the restoring is repeatedly performed.

5. The etching method of Claim 3, comprising:
decreasing an internal pressure of the processing container from one pressure to another pressure according to an opening timing of the valve; and
increasing the internal pressure of the processing container from the another pressure to the one pressure between one opening of the valve and a next opening of the valve.

6. The etching method of Claim 2, wherein the reservoir includes a first reservoir and a second reservoir,
wherein the valve includes a first valve and a second valve,
wherein the storing includes storing the first etching gas and the second etching gas respectively in the first reservoir and the second reservoir, and
wherein the supplying the first etching gas and the second etching gas to the processing container includes opening the first valve provided downstream of the first reservoir and the second valve provided downstream of the second reservoir, respectively.

7. The etching method of Claim 6, wherein the supplying the first etching gas and the second etching gas to the processing container includes simultaneously opening the first valve and the second valve.

8. The etching method of Claim 2, wherein a second film different in type from the first film is formed on the substrate, and
wherein the valve is closed and an interior of the processing container is exhausted so that the first film, among the first film and the second film, is selectively etched.

9. The etching method of Claim 8, wherein the first film is a silicon oxide film and the second film is a silicon nitride film.

10. The etching method of Claim 1, comprising:
vertically moving a stage, on which the substrate is placed within the processing container, by a driver to change a distance between the stage and a ceiling of the processing container,
wherein the supplying the first etching gas and the second etching gas to the processing container includes:
supplying the first etching gas and the second etching gas to the substrate on the stage positioned at a height set according to a processing condition of the substrate.

11. The etching method of Claim 3, comprising:
detecting the internal pressure of the reservoir by a pressure sensor; and
determining whether there is an abnormality based on the internal pressure.

12. The etching method of Claim 11, wherein the detecting is performed for each opened period and each closed period of the valve that is repeatedly opened and closed.

13. The etching method of Claim 1, wherein a plurality of stages, on which the substrate is placed within the processing container, are provided within the processing container, and
wherein the supplying the first etching gas and the second etching gas to the processing container includes:
collectively supplying the first etching gas and the second etching gas to the substrate placed on each stage.

14. An etching apparatus comprising:
a gas supply source configured to supply each of a first etching gas and a second etching gas that includes at least one selected from the group of an ammonia gas and an amine gas;
a gas flow path to which the first etching gas and the second etching gas are supplied from the gas supply source;
a processing container in which a substrate, on which a first film is formed, is accommodated and to which a downstream end of the gas flow path is connected;
a reservoir provided in the gas flow path; and
a valve provided downstream of the reservoir in the gas flow path, the valve being closed to store the first etching gas and the second etching gas in the reservoir and increase an internal pressure of the reservoir, and then being opened to supply the first etching gas and the second etching gas into the processing container to etch the first film.

15. Software for use in an etching apparatus, comprising:
supplying each of a first etching gas and a second etching gas that includes at least one selected from the group of an ammonia gas and an amine gas from a gas supply source to a gas supply path;
storing the first etching gas and the second etching gas in a reservoir provided in the gas supply path to increase an internal pressure of the reservoir; and
supplying the first etching gas and the second etching gas, stored in the reservoir, to a processing container in which a substrate is accommodated by opening a valve provided downstream of the reservoir in the gas supply path, thus etching a first film formed on the substrate.

16. The software of Claim 15, wherein the reservoir includes a first reservoir and a second reservoir,
wherein the valve includes a first valve and a second valve,
wherein the storing includes storing the first etching gas and the second etching gas respectively in the first reservoir and the second reservoir,
wherein the supplying the first etching gas and the second etching gas to the processing container includes simultaneously opening the first valve provided downstream of the first reservoir and the second valve provided downstream of the second reservoir, and
wherein, based on a first parameter set to calculate a virtual internal pressure of the first reservoir and a second parameter set to calculate a virtual internal pressure of the second reservoir, the program causes the etching apparatus to perform detecting an abnormality in a virtual internal pressure difference between the first reservoir and the second reservoir.
